(19) Europäisches Patentamt
European Patent Office
Office européen des brevets

(11) **EP 3 769 382 B1**

(12) **EUROPEAN PATENT SPECIFICATION**

(45) Date of publication and mention
of the grant of the patent:
**09.10.2024 Bulletin 2024/41**

(21) Application number: **19715250.7**

(22) Date of filing: **14.03.2019**

(51) International Patent Classification (IPC):
**H01S 5/183** *(2006.01)* **H01S 5/42** *(2006.01)*

(52) Cooperative Patent Classification (CPC):
**H01S 5/423; G01S 7/4815; G01S 17/42;
H01S 5/04256; H01S 5/18305; H01S 5/18394;**
G01S 7/4818; H01S 5/026; H01S 5/18313;
H01S 5/18388; H01S 2301/176; H01S 2301/18;
H01S 2301/185

(86) International application number:
**PCT/JP2019/010712**

(87) International publication number:
**WO 2019/181757 (26.09.2019 Gazette 2019/39)**

(54) **SURFACE-EMITTING LASER ARRAY, DETECTION DEVICE, AND LASER DEVICE**

OBERFLÄCHENEMITTIERENDE LASERANORDNUNG, DETEKTIONSVORRICHTUNG UND LASERVORRICHTUNG

RÉSEAU LASER À ÉMISSION DE SURFACE, DISPOSITIF DE DÉTECTION ET DISPOSITIF LASER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.03.2018 JP 2018051629
28.12.2018 JP 2018248473**

(43) Date of publication of application:
**27.01.2021 Bulletin 2021/04**

(73) Proprietor: **Ricoh Company, Ltd.
Tokyo 143-8555 (JP)**

(72) Inventors:
• **NUMATA, Masayuki**
**Tokyo 143-8555 (JP)**
• **IKEOH, Toshiyuki**
**Tokyo 143-8555 (JP)**
• **IZUMIYA, Kazuma**
**Tokyo 143-8555 (JP)**
• **UENO, Tsuyoshi**
**Tokyo 143-8555 (JP)**
• **JIKUTANI, Naoto**
**Tokyo 143-8555 (JP)**

(74) Representative: **J A Kemp LLP
80 Turnmill Street
London EC1M 5QU (GB)**

(56) References cited:
**WO-A2-02/05397 WO-A2-2011/021139
GB-A- 2 347 559 US-A1- 2007 217 473
US-A1- 2015 124 433 US-A1- 2016 254 638**

## Description

### Technical Field

The present invention relates to a surface-emitting laser array, a detection device, and a laser device.

### Background Art

A surface-emitting laser array, in which multiple surface-emitting laser elements (vertical cavity surface emitting lasers (VCSEL)) are arranged two-dimensionally, is used as a laser light source.

Conventionally, a VCSEL array, in which a laminated body including an active layer is formed on a semiconductor substrate and a light emitting window is formed on the back side of the substrate, has been proposed (for example, see Patent Literature 1). WO 02/05397 A2 discloses a vertical cavity surface emitting laser (VCSEL) device containing one VCSEL or an array of VCSELs. Each VCSEL has a corresponding integrated microlens.

US 2016/254638 A1 discloses a semiconductor surface emitting array including VCSEL or RC-LED array and an array of microlens elements to generate a wide range of structured light illumination patterns

US 2007/217473 A1 discloses laser equipment including: a surface emitting laser for emitting an excitation light; a light converter for outputting an output light by receiving the excitation light; and a lens portion for collimating or concentrating a light.

GB 2 347 559 A discloses a method for fabricating a VCSEL using wafer bonding. WO 2011/021139 A2 discloses a laser device comprising at least one large area VCSEL and at least one optical feedback element providing an angular-selective feedback for laser radiation emitted from the laser. The angular-selective feedback is higher for at least one portion of laser radiation emitted at angles θ > 0 to the optical axis of the laser than for laser radiation emitted on said optical axis.

### Summary of Invention

### Technical Problem

However, in the conventional VCSEL, it is difficult to control a radiation angle of a laser beam emitted from the VCSEL element.

The present invention has been conceived in view of the foregoing situations, and an object is to control a radiation angle of a laser beam emitted from a surface-emitting laser.

### Solution to Problem

According to an aspect of the present invention, there is provided a surface-emitting laser array, detection device, light receiver and laser device as specified in the claims.

### Advantageous Effects of Invention

According to an embodiment of the present invention, it is possible to control a radiation angle of a laser beam emitted from a surface-emitting laser.

### Brief Description of Drawings

[fig.1]Fig. 1 is a partial lateral cross-sectional view illustrating an example of a configuration of a surface-emitting laser array according to a first example.

[fig.2]Fig. 2 is a partial bottom view illustrating an example of the configuration of the surface-emitting laser array according to the first example.

[fig.3A]Fig. 3A is a cross-sectional view schematically illustrating an example of the flow of a method of generating a light shielding member 42 according to the first example.

[fig.3B]Fig. 3B is a cross-sectional view schematically illustrating the example of the flow of the method of generating the light shielding member 42 according to the first example.

[fig.3C]Fig. 3C is a cross-sectional view schematically illustrating the example of the flow of the method of generating the light shielding member 42 according to the first example.

[fig.4]Fig. 4 is a partial cross-sectional view illustrating another example of the configuration of the surface-emitting laser array according to the first example. [fig.5]Fig. 5 is a partial cross-sectional view illustrating an example of a configuration of a surface-emitting laser array according to a comparative example.

[fig.6]Fig. 6 is a partial bottom view illustrating an example of a configuration of a surface-emitting laser array according to a second example.

[fig.7]Fig. 7 is a partial lateral cross-sectional view illustrating an example of a configuration of a surface-emitting laser array according to a first embodiment.

[fig.8]Fig. 8 is a partial bottom view illustrating an example of the configuration of the surface-emitting laser array according to the first embodiment.

[fig.9]Fig. 9 is a diagram illustrating an intensity distribution of light that has passed through a microlens when a light shielding member is not provided.

[fig.10]Fig. 10 is a diagram illustrating an intensity distribution of light that has passed through the microlens when a light shielding member is provided on only a residual portion.

[fig.11]Fig. 11 is a diagram illustrating an intensity distribution of light that has passed through the microlens when the light shielding member is provided on the residual portion and a peripheral portion of the lens.

[fig.12]Fig. 12 is a cross-sectional view illustrating an example of a configuration of a microlens part of a surface-emitting laser array.

[fig.13]Fig. 13 is a schematic diagram illustrating an example of a configuration of a LiDAR device according to a third embodiment.

[fig.14]Fig. 14 is a schematic diagram illustrating an example of a configuration of a laser device according to a fourth embodiment.

## Description of Embodiments

Exemplary embodiments of a surface-emitting laser array, a detection device, and a laser device will be described in detail below with reference to the accompanying drawings. The present invention is not limited by the embodiments below.

First Example

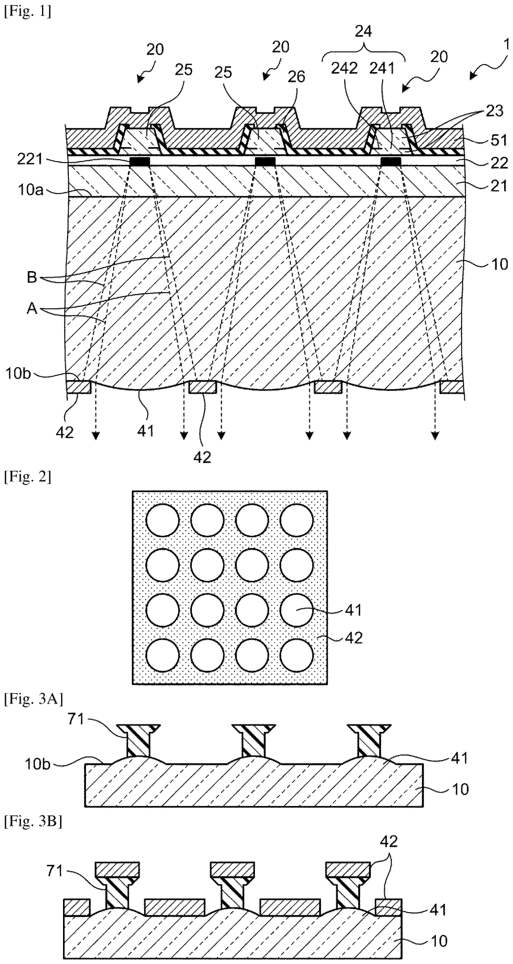

Fig. 1 is a partial lateral cross-sectional view illustrating an example of a configuration of a surface-emitting laser array according to a first example, and Fig. 2 is a partial bottom view illustrating an example of the configuration of the surface-emitting laser array according to the first example.

A surface-emitting laser array 1 includes a plurality of surface-emitting laser elements 20 (hereinafter, referred to as light emitting elements) that are arranged on a first surface 10a of a semiconductor substrate 10, a plurality of microlenses 41 that are arranged on a second surface 10b, a light shielding member 42 that is provided on the second surface 10b, and a surface electrode 51. In the example illustrated in Fig. 1, the n-type semiconductor substrate 10 is used. Further, the semiconductor substrate 10 is made of a material that is transparent to laser beams emitted by the light emitting elements 20.

The light emitting elements 20 are elements that emit laser beams in a direction crossing the first surface 10a (in general, in a perpendicular direction). Each of the light emitting elements 20 includes a lower reflecting layer 21, a resonator constructing layer 22, an upper reflecting layer 23, a current constriction layer 24, and a protection film 26.

The lower reflecting layer 21 is arranged on the semiconductor substrate 10 and constructed with a semiconductor multilayer, in which a high refractive index n-type semiconductor film having an optical thickness of $\lambda/4$ (here, $\lambda$ is one wavelength of a laser beam emitted from the light emitting element 20) and a low refractive index n-type semiconductor film having an optical thickness of $\lambda/4$ are alternately and repeatedly laminated.

The resonator constructing layer 22 is a layer that is arranged between the lower reflecting layer 21 and the upper reflecting layer 23 and constructs an optical resonator. For example, the resonator constructing layer 22 has a structure in which an active region is sandwiched between a lower spacer layer and an upper spacer layer. The lower spacer layer and the upper spacer layer are constructed with, for example, non-doped semiconductor layers. The active region includes a semiconductor material that is selected depending on a wavelength of a laser beam to be emitted. A thickness of the resonator constructing layer 22 in a direction perpendicular to the first surface 10a of the semiconductor substrate 10 is set to, for example, one wavelength ($=\lambda$) of the laser beam emitted from the light emitting element 20. Further, a wavelength that is not absorbed by the semiconductor substrate 10 is selected as a wavelength of a laser beam emitted from the resonator constructing layer 22.

The upper reflecting layer 23 is arranged on the resonator constructing layer 22 and constructed with a semiconductor multilayer, in which a high refractive index p-type semiconductor film having an optical thickness of A /4 and a low refractive index p-type semiconductor film having an optical thickness of A /4 are alternately and repeatedly laminated.

The current constriction layer 24 is a layer that is provided inside the upper reflecting layer 23 in order to reduce an electric current passage area. The current constriction layer 24 includes a current constriction region 241 that is provided in a predetermined region including a center of the position at which the light emitting element 20 is formed, and an oxidized region 242 that is provided on the periphery of the current constriction region 241. By reducing the electric current passage area using the current constriction layer 24, it is possible to reduce a lasing threshold. The current constriction region 241 is made of the same material as the semiconductor film that forms the upper reflecting layer 23, and the oxidized region 242 is made of a material that is obtained by oxidizing the same semiconductor film as the current constriction region 241.

The upper reflecting layer 23 and the current constriction layer 24 are processed into mesa shapes on the resonator constructing layer 22. In other words, the upper reflecting layer 23 and the current constriction layer 24 are configured so as to be separated from those of the adjacent light emitting elements 20. In the following description, the upper reflecting layer 23 and the current constriction layer 24 processed into the mesa shapes will be referred to as a mesa structure 25. In the first example, the mesa structures 25 are provided so as to be located at lattice points of a square lattice (hereinafter, referred to as a square-lattice shape) on the first surface 10a of the semiconductor substrate 10.

The protection film 26 is provided so as to cover side surfaces of the mesa structure 25 and the resonator constructing layer 22. In other words, the protection film 26 is provided on the resonator constructing layer 22, on which the mesa structure 25 is provided, such that a top surface of the mesa structure 25 is exposed.

The microlenses 41 are provided on the second surface 10b of the semiconductor substrate 10 to correspond to arrangement positions of the light emitting elements 20. Because the light emitting elements 20 (the mesa structures 25) are arranged in the square-lattice shape, the microlenses 41 are also arranged in the square-lattice shape as illustrated in Fig. 2. The microlenses 41 are optical elements that reduce radiation angles of laser beams emitted from the corresponding light emitting elements 20. By reducing the radiation angles of the laser beams, it is possible to reduce a spot diameter when the laser beams that have passed through the microlenses 41 are collected onto a target object via a condenser lens or the like. The microlenses 41 are obtained by, for example, processing regions that correspond to the arrangement positions of the light emitting elements 20 on the second surface 10b side of the semiconductor substrate 10 into convex lens shapes. In this example, the radiation angle means an angle at which 10% of the maximum intensity of a laser beam is obtained.

To control the radiation angle of a laser beam emitted from a surface-emitting laser by using a lens, it is desirable to use a lens with a long focal length. For example, it is desirable to ensure a certain optical length (up to about hundreds micrometers ($\mu$m)) between a light emitting unit and a lens. However, if the optical length between the light emitting unit and the lens is increased, a beam diameter is increased until the laser beam reaches the lens part. As a result, the beam diameter at the lens part may exceed a lens diameter and the laser beam may enter a residual portion between the lenses, so that stray light may occur. Therefore, in the first example, the light shielding member 42 is arranged on the residual portions to prevent stray light.

As illustrated in Fig. 2, the light shielding member 42 covers gaps between the microlenses 41 on the second surface 10b of the semiconductor substrate 10 and has a function to reflect or absorb light emitted from the light emitting elements 20. With this configuration, as illustrated in Fig. 1, laser beams B that reach outer peripheries of the microlenses 41 among laser beams emitted from the light emitting elements 20 are not emitted from the second surface 10b of the semiconductor substrate 10. Further, the light shielding member 42 prevents laser beams emitted by the light emitting elements 20 corresponding to the adjacent microlenses 41 from reaching the subject microlens 41, so that it is possible to largely reduce stray light. As the light shielding member 42, a metal film that reflects laser beams, a semiconductor multilayer reflective film, or a semiconductor film that has a smaller bandgap than the laser beams emitted by the light emitting elements 20 and that absorbs the laser beams may be used. The semiconductor multilayer reflective film and the semiconductor film are formed by, for example, epitaxial growth on the second surface 10b side of the semiconductor substrate 10. Meanwhile, the light shielding member 42 is not limited to those as described above, and, for example, may be made of a material that can be applied by a spin coating method. Further, while the light shielding member 42 in film form is described in this example, the light shielding member 42 is not limited to film form and may be in bulk form.

A preferable size of a lens diameter $\varphi$ of the microlens 41 (a diameter of the lens) will be described below. When the microlenses 41 are formed by performing dry etching on the semiconductor substrate 10 using lens-shaped photoresists as masks, the lens diameter $\varphi$ of each of the microlenses 41 needs to be smaller than a pitch X between the light emitting elements 20 in order to prevent interference between the photoresists. In other words, a gap of X- $\varphi$ is present between the adjacent microlenses 41, and this gap will be referred to as a residual. By coating the residuals with the light shielding member 42 that prevents transmission of laser beams, it is possible to prevent stray light and collect light beams with a small beam spot diameter.

The surface electrode 51 is provided on the protection films 26 of the light emitting elements 20. The protection films 26 are not provided on the upper parts of the mesa structures 25, and therefore, the surface electrode 51 comes in electrical contact with the upper reflecting layers 23. Further, a back surface electrode is provided on the second surface 10b side of the semiconductor substrate 10. The surface electrode 51 and the back surface electrode are provided to cause electrical currents to flow into the active regions of the light emitting elements 20. When the light shielding member 42 is made of a conductive material, the light shielding member 42 may also function as the back surface electrode.

It may be possible to use a GaAs substrate as the semiconductor substrate 10, and use InGaAs as the active layers. When InGaAs is used as the active layers, a peak wavelength of an oscillation spectrum of each of the light emitting elements 20 is in a range of about 860 to 1200 nanometers (nm). Further, a wavelength band at around 940 nm that is included in the above-described wavelength band is one of wavelength bands that are absorbed by earth's atmosphere, the spectrum of the sunlight has a relatively low intensity around 940 nm, and if applied to a measurement distance device using a laser beam, it is possible to construct a system with low noise. Furthermore, similarly, the wavelength band of 940 nm is a wavelength band $_{where}$ an absorption coefficient of Yb:YAG (yttrium aluminum garnet) is large, so that it is possible to excite Yb:YAG solid-state laser with high efficiency. Moreover, InGaAs is a material that exhibits compressive strain with respect to GaAs and has a high differential gain when used as an active layer of a semiconductor laser. Therefore, it is possible to realize low threshold oscillation, so that it is possible to provide the surface-emitting laser array 1 with high efficiency.

Furthermore, it may be possible to use an InP substrate as the semiconductor substrate 10, and use InGaAs as the active layers. In this case, the peak wavelength of the oscillation spectrum of each of the light emitting elements 20 is in a range of 1.3 to 1.6 $\mu$m.

It may be possible to use, as the lower reflecting layer 21 and the upper reflecting layer 23, a laminate in which multiple pairs of Al(Ga)As films with different aluminum compositions are laminated. It may be possible to use, as the current constriction layer 24, an AlAs film or an AlGaAs film that is a material used for the upper reflecting layer 23. Further, while the semiconductor multilayer reflective films are used as the lower reflecting layer 21 and the upper reflecting layer 23 in this example, it may be possible to use a dielectric multilayer reflective layer in which a low refractive index dielectric film and a high refractive index dielectric film are alternately and repeatedly laminated. As the dielectric multilayer film as described above, for example, it may be possible to use a laminate in which tantalum pentoxide and silicon dioxide ($Ta_2O_5/SiO_2$) are alternately and repeatedly laminated. However, in this case, it is impossible to cause electrical currents to flow into the lower reflecting layer 21 and the upper reflecting layer 23, and therefore, it is necessary to form electrodes by adopting an intra-cavity structure.

It may be possible to use AlGaInP, GaInP, AlGaAs, or the like as the lower spacer layers and the upper spacer layers inside the resonator constructing layers 22. Further, it may be possible to use InGaAsP as the active layers.

It may be possible to use, as the surface electrode 51, a multilayer film of Cr/ AuZn/Au or Ti/Pt/Au laminated in this order from the first surface 10a side. When these materials are used as the surface electrode 51, the topmost surface is made of Au that is chemically stable, so that it is possible to obtain high reliability. Further, it may be possible to use a metal capable of realizing Ohmic contact as the material of the back surface electrode. It may be possible to use, as the back surface electrode, a multilayer film of AuGe/Ni/Au laminated in this order from the second surface 10b side.

It may be possible to use a metal material, such as Au, as the light shielding member 42. Meanwhile, when a metal material, such as Au, is used as the light shielding member 42, the light shielding member 42 may also function as the back surface electrode.

While the example has been described above in which the n-type semiconductor substrate 10 is used, it may be possible to use the p-type semiconductor substrate 10. In this case, the current constriction layer 24 is provided on the lower reflecting layer 21 side. Further, in this case, it may be possible to use, as the surface electrode 51, a multilayer film of AuGe/Ni/Au laminated in this order from the first surface 10a side. Furthermore, it may be possible to use, as the back surface electrode, a multilayer film of Cr/AuZn/Au or Ti/Pt/Au laminated in this order from the second surface 10b side.

Next, a method of manufacturing the surface-emitting laser array 1 configured as above will be described. As a method of manufacturing the light emitting elements 20, a well-known technique is applicable, and therefore, only summary thereof will be described. A method of generating the light shielding member 42 will be described with reference to the drawings. Figs. 3A to 3C are cross-sectional views schematically illustrating an example of the flow of the method of generating the light shielding member 42 according to the first example. In Figs. 3A to 3C, the semiconductor substrate 10 is arranged with the second surface 10b facing upward.

First, semiconductor layers including the lower reflecting layers 21, the resonator constructing layers 22 including the active layers, and the upper reflecting layers 23 are deposited on the first surface 10a of the semiconductor substrate 10. As a method of forming the semiconductor layers, for example, a metal organic chemical vapor deposition (MOCVD) method, a molecular beam epitaxy (MBE) method, or the like may be used.

Subsequently, photoresists are applied onto the upper reflecting layers 23, and exposure processing based on the lithography technique and developing processing are preformed, so that resist patterns are generated in regions in which the mesa structures 25 are formed. Thereafter, etching is performed based on the dry etching technique, such as the reactive ion etching (RIE) method, using the resist patterns as masks until the resonator constructing layers 22 are exposed, so that the mesa structures 25 are formed. Top surfaces of the mesa structures 25 may be formed in, for example, circular shapes, elliptical shapes, square shapes, rectangular shapes, or any other shapes. Further, the mesa structures 25 are formed so as to be arranged in the square-lattice shape on the first surface 10a.

Thereafter, the semiconductor films that are exposed on the side surfaces of the mesa structures 25 and that serve as the current constriction layers 24 are oxidized by being subjected to, for example, high-temperature treatment in a water-vapor atmosphere, so that the oxidized regions 242 are formed on the peripheral portions of the semiconductor films. Regions that are not oxidized in the semiconductor films that constitute the current constriction layers 24 serve as the current constriction regions 241. Thus, the current constriction layers 24 are formed.

Meanwhile, when InGaAs is used for the active layers, because InGaAs is a material that does not contain Al that is chemically active, a small amount of oxygen that is present in a reaction room during crystal growth is less likely to be introduced into the active layers. With this configuration, it is possible to provide the surface-emitting laser array 1 with high reliability.

Subsequently, the protection films 26 are formed on the entire resonator constructing layers 22 having the mesa structures 25. As a method of forming the protection films 26, for example, a plasma CVD method or the like may be used. Thereafter, photoresists are applied onto the protection films 26 by a spin coating method or the like, and exposure processing based on the lithography technique and developing processing are preformed, so that resist patterns in which the top surfaces of the mesa structures 25 are opened are formed. Then, the protection films 26 formed on the top surfaces of the mesa structures 25 are removed by the anisotropic etching technique, such as the RIE method, using the resist patterns as masks. With this operation, openings are formed in the protection films 26 at positions corresponding to the top surfaces of the mesa structures 25. After the resist patterns are removed, the surface electrode 51 is formed on the protection films 26. With this operation, the surface electrode 51 is electrically connected to the upper reflecting layers 23.

Thereafter, a photoresist is applied onto the second surface 10b of the semiconductor substrate 10, and, for example, exposure processing based on the gray-tone mask lithography technique and developing processing are preformed, so that a resist pattern in which lens shapes are formed at positions where the microlenses 41 are to be formed is formed. Subsequently, etching is performed based on the dry etching technique, such as the RIE method, using the resist pattern as a mask, so that the microlenses 41 are formed on the second surface 10b of the semiconductor substrate 10. The microlenses 41 are formed in the square-lattice shape to correspond to the light emitting elements 20 that are formed on the first surface 10a.

Meanwhile, the method of forming the microlenses 41 is not limited to the above-described example. For example, it may be possible to cause epitaxial growth of semiconductor films to occur on the second surface 10b of the semiconductor substrate 10, apply resists on the semiconductor films, and perform patterning such that the resists remain at positions where the microlenses 41 are to be formed. Thereafter, resist patterns are formed by deforming the resists into convex lens shapes by reflowing the resists. Then, etching is performed on the epitaxially grown semiconductor films based on the dry etching technique, such as the RIE method, using the resist patterns as masks, so that semiconductor films in the forms of the microlenses 41 are formed.

Further, it may be possible to form the microlenses 41 by dropping solution of cured resin precursor with optical transparency at the positions where the microlenses 41 are to be formed on the second surface 10b of the semiconductor substrate 10, and curing the precursor. Furthermore, it may be possible to form the microlenses 41 by methods other than those as described above.

Thereafter, as illustrated in Fig. 3A, a resist is applied onto the second surface 10b of the semiconductor substrate 10 on which the microlenses 41 are formed, and exposure processing based on the lithography technique and developing processing are preformed, so that resist patterns 71 for liftoff are formed on the microlenses 41.

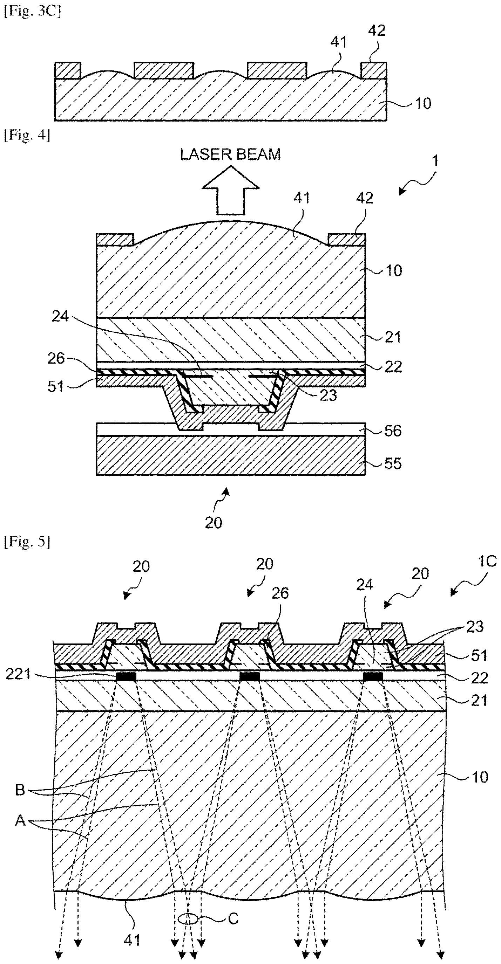

Subsequently, as illustrated in Fig. 3B, the light shielding member 42 is formed on the second surface 10b on which the resist patterns 71 are formed. The light shielding member 42 is film-formed by a vacuum evaporation method, a sputtering method, or the like depending on a type of the light shielding member 42. The light shielding member 42 is formed on the second surface 10b and the resist patterns 71. Then, as illustrated in Fig. 3C, the resist patterns 71 are lifted off to remove unnecessary portions, so that the light shielding member 42 remains in regions other than the microlenses 41. Through the above-described operation, the surface-emitting laser array 1 as illustrated in Fig. 2 is obtained.

Meanwhile, by using a metal material, such as Au, as the light shielding member 42, it is possible to cause the light shielding member 42 to also further function as the back surface electrode. With this configuration, it is possible to simultaneously form the light shielding member 42 and the back surface electrode, so that it is possible to simplify a manufacturing process. At this time, it is possible to form the back surface electrode in the same manner as described above with reference to Figs. 3A to 3C.

The configuration of the surface-emitting laser is not limited to the configuration as illustrated in Fig. 1. Fig. 4 is a partial cross-sectional view illustrating another example of the configuration of the surface-emitting laser array according to the first embodiment. In Fig. 4, the surface-emitting laser array is illustrated upside down as compared to Fig. 1, and the surface electrode 51 is connected to a heatsink 55 via a joint material 56. It may be possible to use an electrode instead of the joint material 56. Meanwhile, the same components as those illustrated in Fig. 1 are denoted by the same reference symbols, and explanation thereof will be omitted.

With this configuration, a distance between peripheries of the active layers that mainly generate heat at the time of operation and the heatsink 55 is reduced, so that radiation performance is improved, and it is possible to improve efficiency of the surface-emitting laser array 1.

Next, an effect of the first example will be described in comparison with a comparative example in which the light shielding member 42 is not provided on the second surface 10b of the semiconductor substrate 10. Fig. 5 is a partial cross-sectional view illustrating an example of a configuration of a surface-emitting laser array according to the comparative example. Meanwhile, the same components as those illustrated in Fig. 1 are denoted by the same reference symbols, and explanation thereof will be omitted. Specifically, in a surface-emitting laser array 1C of the comparative example, the light shielding member 42 is not provided in a region other than the positions where the microlenses 41 are formed on the second surface 10b of the semiconductor substrate 10.

Laser beams that oscillate from a light-emitting region 221 inside the resonator constructing layer 22 of each of the light emitting elements 20 pass through the semiconductor substrate 10 and are output to the outside via the microlens 41. At this time, laser beams A that pass through the inside of the microlens 41 directly enter a condenser lens. However, laser beams B that are output from the outside of the microlens 41, that is, from the residuals between the microlenses 41 on the second surface 10b, become stray light. Then, the stray light may increase the spot diameter when the laser beams are collected via the condenser lens or the like.

In the first example, the laser beams A that pass through the inside of the microlens 41 among the laser beams that oscillate from the light-emitting region 221 inside the resonator constructing layer 22 of each of the light emitting elements 20 directly enter a condenser lens, similarly to the comparative example. In contrast, the laser beams B that reach the residuals outside the microlens 41 are reflected or absorbed by the light shielding member 42. Further, unexpected laser beams that are incident from the other light-emitting regions 221 onto the microlens 41 are also reflected or absorbed by the light shielding member 42. As a result, it is possible to largely reduce stray light that is output from the residual portions to the outside of the surface-emitting laser array 1. By largely reducing the stray light, it is possible to control radiation angles of laser beams emitted from the surface-emitting lasers, so that it is possible to reduce the radiation angles at the time the laser beams emitted from the light-emitting regions 221 pass through the microlenses 41. Therefore, it is possible to reduce a size of a target object, such as a reflecting mirror, that is for performing laser beam scanning, so that it is possible to reduce the size of the device as compared to the comparative example.

Further, the microlenses 41 are formed on the second surface 10b of the semiconductor substrate 10 by performing etching on the semiconductor substrate 10 or curing resin that is transparent to laser beams. Therefore, it is not necessary to manufacture the microlenses 41 from silica, glass, or the like and then mount the microlenses 41, so that it is possible to reduce the number of components and manufacturing processes, enabling to manufacture the surface-emitting laser array 1 at low costs.

Second example

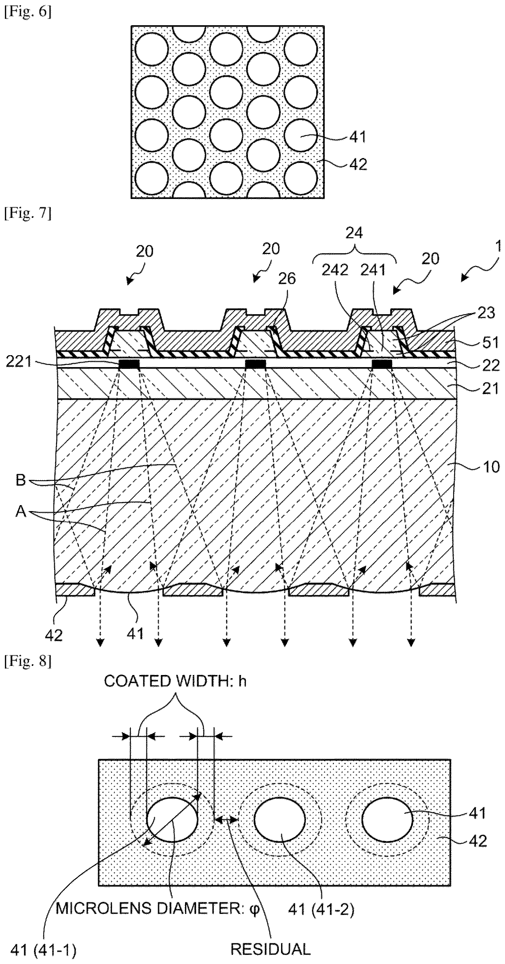

Fig. 6 is a partial bottom view illustrating an example of a configuration of a surface-emitting laser array according to a second example. Fig. 6 is a diagram of the surface-emitting laser array 1 viewed from the second surface 10b side of the semi- conductor substrate 10. In the first example, the microlenses 41 are arranged in the square-lattice shape in accordance with the arrangement positions of the light emitting elements 20. In contrast, in the second example, the light emitting elements 20 and the microlens 41 are provided so as to be located at all of corners and centers of regular hexagons. Other configurations are the same as those of the first example, and therefore explanation thereof will be omitted.

In the second example, the light emitting elements 20 and the microlens 41 are provided so as to be located at all of corners and centers of regular hexagons, so that when the light emitting elements 20 are arranged at equal intervals, it is possible to arrange the light emitting elements 20 in a most densely manner. As a result, to obtain the same laser beam output, it is possible to reduce a chip size as compared to the arrangement of the first example illustrated in Fig. 2.

First Embodiment

Fig. 7 is a partial lateral cross-sectional view illustrating an example of a configuration of a surface-emitting laser array according to a first embodiment, and Fig. 8 is a partial bottom view illustrating an example of the configuration of the surface-emitting laser array according to the first embodiment. In the surface-emitting laser array 1 according to the first embodiment, the light shielding member 42 provided on the second surface 10b side of the semiconductor substrate 10 covers not only the residual portions but also peripheral portions in a predetermined range from outer edges of the microlenses 41. Meanwhile, the same components as those of the first example will be denoted by the same reference symbols, and explanation thereof will be omitted.

As described above, to reduce the radiation angles (divergence angles) of the laser beams emitted from the light emitting elements 20, it is necessary to increase the thickness of the semiconductor substrate 10 and collect the laser beams by the microlenses 41 with increased focal lengths. However, if the thickness of the semiconductor substrate 10 is increased, laser beams from a certain light emitting element enter the microlenses 41 corresponding to the adjacent light emitting elements, in particular, enter the peripheral portions of the microlenses 41, due to divergence of the laser beams inside the semiconductor substrate 10, so that stray light may occur. Therefore, by providing the light shielding member 42 so as to cover the peripheral portions from the outer edges of the microlenses 41 as in the first embodiment, it is possible to reduce the radiation angles of the emitted laser beams while preventing stray light caused by the laser beams B emitted from the adjacent light emitting elements 20, so that it is possible to further reduce a light condensing spot dimeter.

Further, in a general microlens formation method, it is difficult to form even the peripheral portions of the microlenses 41 into desired shapes. Therefore, in some cases, curvatures of the peripheral portions of the microlenses 41 may be deviated from the curvatures of the central portions of the microlenses 41. If a microlens array configured as above is used, light that enters the peripheral portions in which target curvatures are not obtained may become stray light even when the light is emitted from the light emitting units that correspond to the lenses.

In the first embodiment, the light shielding member 42 covers not only the residual portions but also the peripheral portions of the microlenses 41, so that it is possible to prevent stray light that may occur due to the laser beams emitted from the light emitting unit corresponding to the lens.

A desirable range of the peripheral portions of the microlenses 41 to be covered by the light shielding member 42 will be described below. As described above, in general, it is difficult to manufacture peripheral portions of a microlens array with desired curvatures. Portions outside the effective ranges of the peripheral portions may have sizes of 10% of the lens diameters $\varphi$ (5% from outer circumferences of the lenses) at a maximum, depending on manufacturing methods.

In contrast, if the light shielding member 42 is provided in the effective ranges of the lenses, laser beams that are expected to be subjected to desired beam shaping are blocked, so that output from the surface-emitting laser is reduced. Therefore, it is desirable to appropriately select, depending on profiles, a range of the peripheral portions of the microlenses 41 in which the light shielding member 42 is to be provided, within a range of 0 to $\varphi/20$ from the outer circumferences of the lenses.

A coated width h of the light shielding member 42 from the outer edge of the microlens 41 falls in a range of 0 $\leqq 2h \leqq \varphi/10$, as illustrated in Fig. 8. In this manner, the light shielding member 42 is provided on the residual portions between the microlenses 41 and the peripheral portions with the coated widths h in the range of 0 $\leqq 2h \leqq \varphi/10$ from the outer edges of the microlenses 41.

Next, a desirable thickness of the semiconductor substrate 10 will be described. As described above, if the thickness of the semiconductor substrate 10 is increased, it is possible to collect emitted laser beams with a smaller beam spot diameter. However, the beam diameters inside the semiconductor substrate 10 are increased, and the laser beams enter the adjacent microlenses 41, so that stray light occurs. A beam diameter D that is obtained when a laser beam emitted from each of the light emitting elements 20 enters the microlens 41 arranged on the semiconductor substrate 10 is represented by Expression (1) below, where the size of the light-emitting region 221 of the light emitting element 20 (the maximum opening length of the current constriction region 241) is denoted by a, the radiation angle of the laser beam inside the semiconductor substrate 10 is denoted by $\theta$, and a distance from the light emitting unit to a lens emission surface is denoted by t. Here, a lens height is very small as compared to the substrate thickness, and therefore, t is regarded as constant over the entire emission surface.

$$D = 2t \tan\left(\frac{\theta}{2}\right) + a \qquad (1)$$

It is not preferable that light from the light emitting element 20 enters the microlens 41 (41-2) that is adjacent to the subject microlens 41 (41-1) across the light shielding member of the adjacent microlens 41 (41-2). Therefore, it is preferable to satisfy Expression (2) with respect to the beam diameter D of the laser beam that enters the microlens 41 such that "a pitch X between the microlenses 41 + the width 2h of the light shielding member + a residual X - the lens diameter $\varphi$".

$$D < 2X + 2h - \phi \qquad (2)$$

Based on Expressions (1) and (2), the thickness t of the semiconductor substrate 10 is set to a value that satisfies Expression (3) with respect to the inter-element pitch X and the width 2h of the light shielding member.

$$t < \frac{1}{2 \tan \dfrac{\theta}{2}} \left(2X + 2h - \phi - a\right)$$

$$(3)$$

In particular, when 10% of the lens diameter $\varphi$ is to be covered by the light shielding member, $2h = \varphi/10$, so that Expression (3) is represented as Expression (4).

$$t < \frac{1}{2 \tan \dfrac{\theta}{2}} \left[X + \frac{\phi}{10} - a\right]$$

$$(4)$$

To generate the light shielding member 42 in the surface-emitting laser array 1 as described above, in the process in Fig. 3A, the resist patterns 71 are formed on the microlenses 41 so as to preferably have smaller sizes in the in-plane direction of the substrate as compared to the first example. For example, the sizes of the resist patterns 71 may be set to 90% of the lens diameters $\varphi$ of the microlenses 41. With this configuration, when the light shielding member 42 is formed on the second surface of the semiconductor substrate 10 in Fig. 3B, it is possible to cover regions equal to or smaller than 10% of the lens diameters $\varphi$ in the peripheral portions of the microlenses 41.

Next, a result of simulation performed on the surface-emitting laser of the third embodiment will be described. A surface-emitting laser subjected to the simulation is configured as follows: the size a of the light-emitting region 221 of each of the light emitting elements 20 is 10 $\mu$m, the radiation angle $\theta$ of the laser beam inside the semiconductor substrate 10 is 6 degrees, a semiconductor layer from the light emitting unit to the substrate (mainly, a lower DBR) is 2.8 $\mu$m, the substrate thickness is 300 $\mu$m, the pitch of the light emitting element and the lens is 30 $\mu$m, the lens diameter is 28 $\mu$m, and the inter-lens residual is 2 $\mu$m.

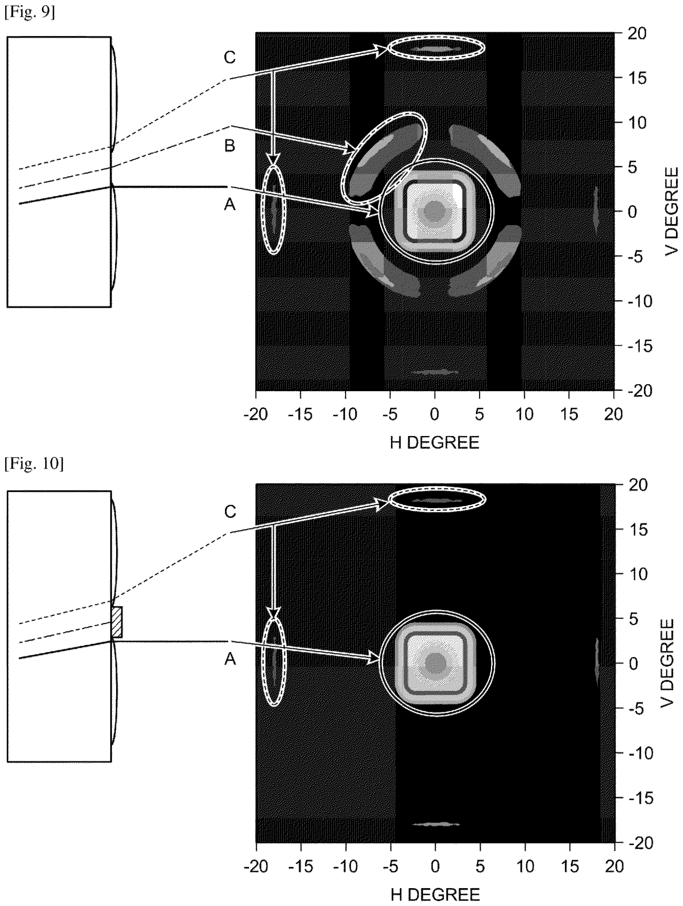

Fig. 9 is a diagram illustrating an intensity distribution of light that has passed through the microlens which is the above-described surface-emitting laser and in which the light shielding member 42 is not provided. Light (A) emitted from the lens corresponding to the light emitting element, light (B) emitted from the residual portion between the lenses, and light (C) emitted from the adjacent lens are observed.

Fig. 10 is a diagram illustrating an intensity distribution of light that has passed through the microlens which is the above-described surface-emitting laser and in which the light shielding member 42 is provided on only the residual portion. As compared to Fig. 9, it is possible to suppress the light (B) emitted from the residual portion between the lenses. In contrast, the light (C) emitted from the adjacent lens are observed similarly to Fig. 9.

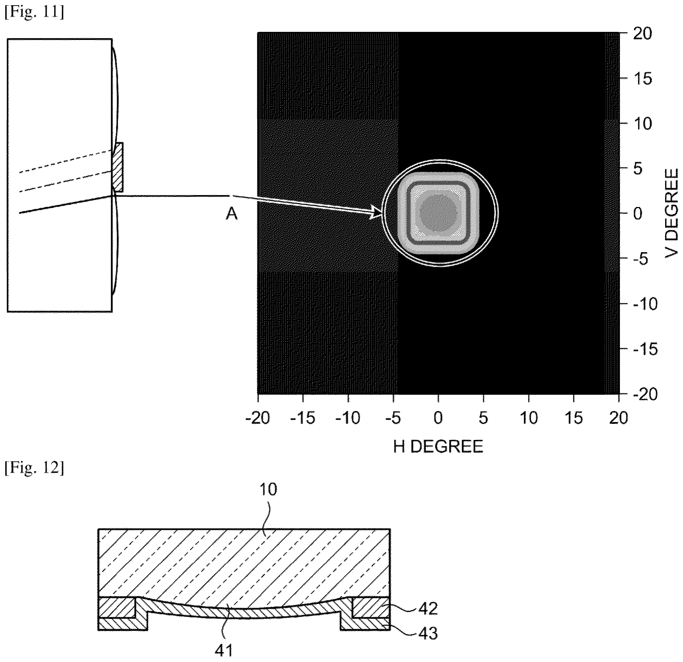

Fig. 11 is a diagram illustrating an intensity distribution of light that has passed through the microlens which is the above-described surface-emitting laser and in which the light shielding member 42 is provided on the residual portion and the peripheral portion of the lens. In this example, the region covered by the light shielding member is set to 10% of the lens diameter. As compared to Fig. 10, it is possible to suppress even the light (C) emitted from the adjacent lens.

Second Embodiment

Fig. 12 is a cross-sectional view illustrating an example of a configuration of a microlens part of a surface-emitting laser array. In the second embodiment, a case will be described in which a transparent conductive material is used for a back surface electrode 43, and the back surface electrode 43 is formed on the entire second surface 10b of the semiconductor substrate 10. As the transparent conductive material, for example, $In_2O_3$:Sn, $SnO_2$:F, ZnO:Al, ZnO:Ga, graphene, or the like may be used. Other configurations are the same as those described in the first or second example or first embodiment.

As a method of manufacturing the surface-emitting laser array 1 configured as above, it is preferable to form the light shielding member 42 on the residual portions between the microlenses 41 as in the first example or form the light shielding member 42 on the peripheral portions of the microlenses 41 in addition to the residual portions as in the first embodiment, and thereafter form the back surface electrode 43 made of the transparent conductive material on the second surface 10b of the semiconductor substrate 10.

In the second embodiment, because the transparent conductive material is used for the back surface electrode 43, it is possible to form the back surface electrode 43 on the entire second surface 10b of the semiconductor substrate 10 on which the microlenses 41 and the light shielding member 42 are formed. With this configuration, it is possible to bring the back surface electrode 43 in close contact with the surfaces of the mi- crolenses 41, so that it is possible to reduce resistance.

Third Embodiment

In a third embodiment, a case will be described in which the surface-emitting laser array 1 described in the first or second example or first or second embodiment is applied to a detection device. Here, a light detection and ranging or laser imaging detection and ranging (LiDAR) device 100, which measures a distance to a target object and performs shape mapping using laser beams will be described as an example of the detection device.

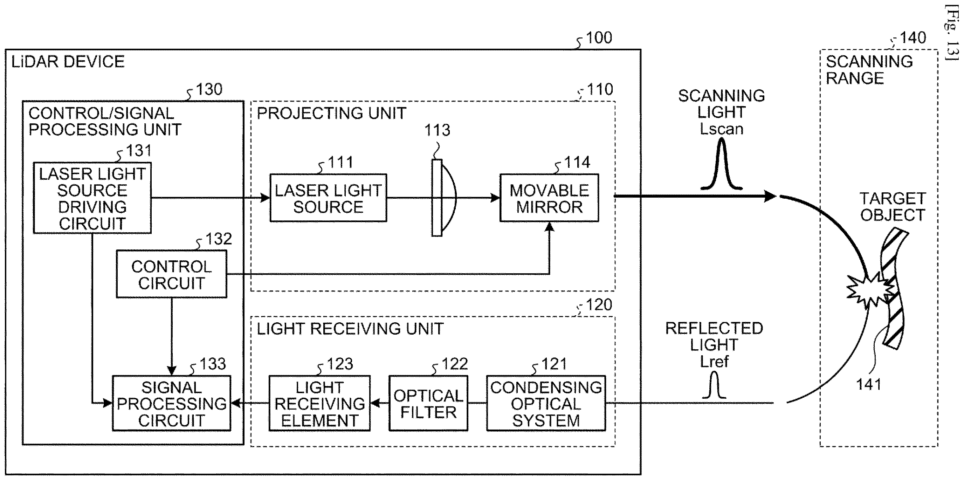

Fig. 13 is a schematic diagram illustrating an example of a configuration of the LiDAR device according to the third embodiment. The LiDAR device 100 is one example of a distance measuring device that optically measures a distance. The LiDAR device 100 includes a projecting unit 110 that projects a laser beam, a light receiving unit 120 that receives reflected light Lref from a target object 141, and a control/signal processing unit 130 that performs distance calculation based on the control of the projecting unit 110 and the received reflected light.

The projecting unit 110 includes a laser light source 111, a projecting lens 113, and a movable mirror 114 serving as a scanning unit. The surface-emitting laser array 1 described in the first or second example or first or second embodiment is used as the laser light source 111.

The movable mirror 114 scans a desired scanning range 140 with a laser beam that is emitted from the projecting lens 113.

The light receiving unit 120 includes a condensing optical system 121, an optical filter 122, and a light receiving element 123. The condensing optical system 121 collects the reflected light Lref from the target object 141, and causes the reflected light Lref to enter the light receiving element 123 via the optical filter 122. The optical filter 122 is a filter that transmits only wavelengths in a predetermined range near the oscillation wavelength of the laser light source. By cutting wavelengths different from the oscillation wavelength, it is possible to improve a signal-to-noise (S/N) ratio of light that enters the light receiving element 123. The light receiving element 123 converts the light that has transmitted through the optical filter 122 into an electrical signal.

The control/signal processing unit 130 includes a laser light source driving circuit 131 that drives the laser light source 111, a control circuit 132 that controls movement (or a deflection angle) of the movable mirror 114, and a signal processing circuit 133 that calculates a distance of the target object 141. The laser light source driving circuit 131 controls a light emission timing and a light emission intensity of the laser light source 111.

Operation of the LiDAR device 100 will be described. Light emitted from the laser light source 111 is guided to the movable mirror 114 by the projecting lens 113, and applied, as scanning light Lscan, to the target object 141 present in the scanning range 140 by the movable mirror 114. The reflected light Lref reflected by the target object 141 is received by the light receiving element 123 via the condensing optical system 121 and the optical filter 122. The light receiving element 123 outputs, as a detection signal, photocurrent corresponding to the amount of incident light. The signal processing circuit 133 performs a distance calculation based on a time lag between a light emission timing signal supplied from the laser light source driving circuit 131 and the detection signal, and calculates a distance from the target object 141.

In the third embodiment, the surface-emitting laser array 1 described in the first or second example or first or second embodiment, in which laser beams emitted from the microlenses 41 can be collected with a small beam spot diameter, is used as the laser light source 111.

Therefore, it is possible to reduce a size of an optical component that receives laser beams emitted from the laser light source 111, so that it is possible to reduce the size of the detection device itself.

Fourth Embodiment

In a fourth embodiment, a case will be described in which the surface-emitting laser array 1 described in the first or second example or first or second embodiment is applied to a laser device.

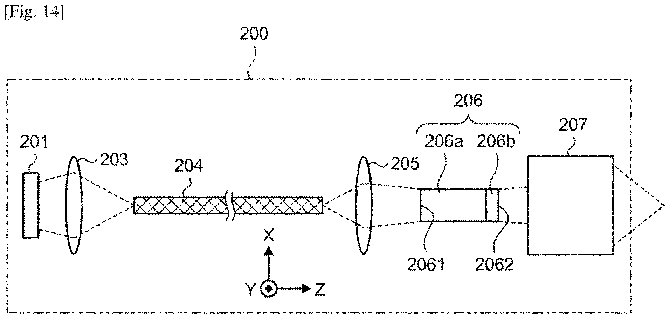

Fig. 14 is a schematic diagram illustrating an example of a configuration of a laser device according to the fourth embodiment. A laser device 200 includes a laser light source 201, a first condensing optical system 203, an optical fiber 204, a second condensing optical system 205, a laser resonator 206, and an emitting optical system 207. In Fig. 14, the XYZ three-dimensional orthogonal coordinates is used, and explanation will be given based on the assumption that a light emission direction from the laser light source 201 corresponds to the positive Z direction.

The laser light source 201 is an excitation light source and includes a plurality of light emitting units. The surface-emitting laser array 1 described in the first or second example or first or second embodiment is used as the laser light source 201. When the laser light source 201 emits light, the plurality of light emitting units emit light simultaneously.

Meanwhile, a surface-emitting laser array is a light source in which wavelength deviation due to temperature can hardly occur, and therefore is favorable for exciting Q switch laser whose characteristics are largely changed due to wavelength deviation. Therefore, using the surface-emitting laser array as an excitation light source is favorable for simplifying operation of controlling an environmental temperature.

The first condensing optical system 203 is a condenser lens and collects light emitted from the laser light source 201. Meanwhile, the first condensing optical system 203 may include a plurality of optical elements.

The optical fiber 204 is arranged such that a center of an end surface of a core on the negative Z side is located at a position at which the first condensing optical system 203 collects light. By providing the optical fiber 204, it is possible to arrange the laser light source 201 at a position separated from the laser resonator 206. Light that has entered the optical fiber 204 propagates inside the core, and is output from an end surface of the core on the positive Z side.

The second condensing optical system 205 is a condenser lens, is arranged on an optical path of light emitted from the optical fiber 204, and collects the light. Meanwhile, a plurality of optical elements may be used as the second condensing optical system 205 depending on the quality of light or the like. Light that is collected by the second condensing optical system 205 enters the laser resonator 206.

The laser resonator 206 is Q switch laser that causes laser beams emitted from the second condensing optical system 205 to resonate and amplifies the laser beams. The laser resonator 206 includes, for example, a solid-state laser medium 206a and a saturable absorber 206b. For example, it may be possible to use Yb:YAG crystal as the solid-state laser medium 206a. For example, it may be possible to use Cr:YAG crystal as the saturable absorber 206b. In the laser resonator 206, the solid-state laser medium 206a and the saturable absorber 206b are bonded together.

Light emitted from the second condensing optical system 205 enters the solid-state laser medium 206a. In other words, the solid-state laser medium 206a is excited by the light emitted from the second condensing optical system 205. Meanwhile, it is desirable that a peak wavelength of light emitted from the laser light source 201 falls in a range of 910 to 970 nm where absorption efficiency of Yb:YAG crystal is the highest. Then, the saturable absorber 206b performs operation as a Q switch.

A surface 2061 of the solid-state laser medium 206a on the incident side (negative Z side) and a surface 2062 of the saturable absorber 206b on the emission side (positive Z side) are subjected to an optical polishing process, and function as mirrors. In the following descriptions, for the sake of convenience, the surface 2061 of the solid-state laser medium 206a on the incident side may be referred to as a "first surface", and the surface 2062 of the saturable absorber 206b on the emission side may be referred to as a "second surface".

Further, the first surface 2061 and the second surface 2062 are coated with dielectric multilayer films corresponding to the wavelength of light emitted from the laser light source 201 and the wavelength of light emitted from the laser resonator 206.

Specifically, the first surface 2061 is coated with a material that has adequately high transmittance with respect to light with the wavelength of 910 to 970 nm and adequately high reflectance with respect to light with the wavelength of 1030 nm. Further, the second surface 2062 is coated with a material that has reflectance that is selected so as to obtain a desired threshold with respect to light with the wavelength of 1030 nm. With this configuration, light resonates and is amplified inside the laser resonator 206.

The emission optical system 207 collects laser pulses emitted from the laser resonator 206 and outputs the laser pulses to the outside.

The laser device configured as above is used as, for example, an ignition system of an internal combustion, a laser processing machine, a laser peening device, a terahertz generator, and the like.

**Reference Signs List**

    1 Surface-emitting laser array
    10 Semiconductor substrate
    10a First surface
    10b Second surface
    20 Light-emitting element
    21 Lower reflecting layer
    22 Resonator constructing layer
    23 Upper reflecting layer
    24 Current constriction layer
    25 Mesa structure
    26 Protection film
    41 Microlens
    42 Light shielding member
    43 Back surface electrode

51 Surface electrode
221 Light-emitting region
241 Current constriction region
242 Oxidized region

**Citation List**

**Patent Literature**

PTL 1: Japanese Laid-open Patent Publication No. 2014-007293

**Claims**

**1.** A surface-emitting laser array (1) comprising:

a plurality of surface-emitting laser elements (20) arranged on a first surface (10a) of a substrate (10) and configured to emit light in a direction crossing the first surface (10a);
a plurality of optical elements arranged on a second surface (10b) opposite to the first surface (10a) of the substrate (10) to correspond to the surface-emitting laser elements (20) and configured to change a radiation angle of the light; and
a light shielding member (42) arranged in a region between the optical elements on the second surface (10b) of the substrate;
**characterised in that** the light shielding member (42) covers peripheral portions of the optical elements, the peripheral portion being a part of the optical element.

**2.** The surface-emitting laser array (1) according to claim 1, wherein the peripheral portion covered by the light shielding member (42) on the optical elements has a width equal to or smaller than 10% of diameters of the optical elements.

**3.** The surface-emitting laser array (1) according to claim 1 or 2, wherein the light shielding member (42) further functions as an electrode on the second surface of the substrate (10).

**4.** The surface-emitting laser array (1) according to claim 1 or 2, further comprising a back surface electrode made of a transparent conductive material and disposed on the optical elements and the light shielding member (42) on the second surface (10b).

**5.** The surface-emitting laser array (1) according to any one of claims 1 to 4, wherein

the substrate (10) is a GaAs substrate, and
the surface-emitting laser elements include active layers made of InGaAs.

**6.** The surface-emitting laser array (1) according to any one of claims 1 to 5, wherein peak wavelengths of the light emitted by the surface-emitting laser elements (20) fall in a range of 910 to 970 nanometers.

**7.** The surface-emitting laser array (1) according to any one of claims 1 to 6, wherein a thickness t of the substrate (10) is represented by Expression (1), where a radiation angle of the light inside the substrate (10) is denoted by $\theta$, a pitch between the surface-emitting laser elements (20) is denoted by X, a diameter of each of the optical elements is denoted by $\varphi$, and a length of a light-emitting region of each of the surface-emitting laser elements (20) is denoted by $a$.

$$t < \frac{1}{2\tan\frac{\theta}{2}}\left[X + \frac{\phi}{10} - a\right]$$

(1)

**8.** A detection device comprising:

the surface-emitting laser array (1) according to any one of claims 1 to 7; and

a light receiver configured to receive light emitted from the surface-emitting laser elements of the surface-emitting laser array.

9. A laser device comprising:

the surface-emitting laser array (1) according to any one of claims 1 to 7; and
a laser resonator including a solid-state laser medium that causes light emitted from the surface-emitting laser array (1) to resonate.

**Patentansprüche**

1. Oberflächenemittierendes Laserarray (1), umfassend:

eine Mehrzahl von oberflächenemittierenden Laserelementen (20), die auf einer ersten Oberfläche (10a) eines Substrats (10) angeordnet sind und dazu konfiguriert sind, Licht in einer Richtung zu emittieren, die die erste Oberfläche (10a) kreuzt;
eine Mehrzahl von optischen Elementen, die auf einer zweiten Oberfläche (10b) gegenüber der ersten Oberfläche (10a) des Substrats (10) angeordnet sind, um den oberflächenemittierenden Laserelementen (20) zu entsprechen, und dazu konfiguriert ist, einen Strahlungswinkel des Lichts zu ändern; und
ein Lichtabschirmelement (42), das in einem Bereich zwischen den optischen Elementen auf der zweiten Oberfläche (10b) des Substrats (10) angeordnet ist,
**dadurch gekennzeichnet, dass** das Lichtabschirmelement (42) periphere Abschnitte der optischen Elemente abdeckt, wobei der periphere Abschnitt ein Teil des optischen Elements ist.

2. Oberflächenemittierendes Laserarray (1) nach Anspruch 1,
wobei der von dem Lichtabschirmelement (42) abgedeckte periphere Abschnitt auf den optischen Elementen eine Breite aufweist, die gleich oder kleiner als 10 % der Durchmesser der optischen Elemente ist.

3. Oberflächenemittierendes Laserarray (1) nach Anspruch 1 oder 2, wobei das Lichtabschirmelement (42) ferner als eine Elektrode auf der zweiten Oberfläche des Substrats (10) fungiert.

4. Oberflächenemittierendes Laserarray (1) nach Anspruch 1 oder 2, ferner umfassend eine Rückseitenelektrode, die aus einem transparenten, leitfähigen Material hergestellt ist und auf den optischen Elementen und dem Lichtabschirmelement (42) auf der zweiten Oberfläche (10b) angeordnet ist.

5. Oberflächenemittierendes Laserarray (1) nach einem der Ansprüche 1 bis 4, wobei

das Substrat (10) ein GaAs-Substrat ist, und
die oberflächenemittierenden Laserelemente aktive Schichten beinhalten, die aus InGaAs hergestellt sind.

6. Oberflächenemittierendes Laserarray (1) nach einem der Ansprüche 1 bis 5, wobei die Spitzenwellenlängen des von den oberflächenemittierenden Laserelementen (20) emittierten Lichts in einen Bereich von 910 bis 970 Nanometern fallen.

7. Oberflächenemittierendes Laserarray (1) nach einem der Ansprüche 1 bis 6, wobei eine Dicke t des Substrats (10) durch den Ausdruck (1) dargestellt wird, wobei ein Strahlungswinkel des Lichts innerhalb des Substrats (10) mit $\theta$ bezeichnet wird, ein Zwischenraum zwischen den oberflächenemittierenden Laserelementen (20) mit X bezeichnet wird, ein Durchmesser jedes der optischen Elemente mit $\varphi$ bezeichnet wird, und eine Länge des lichtemittierenden Bereichs jedes der oberflächenemittierenden Laserelemente (20) durch $a$ bezeichnet wird.

$$t < \frac{1}{2\tan\frac{\theta}{2}}\left[X + \frac{\phi}{10} - a\right]$$

(1)

8. Erkennungsvorrichtung, umfassend:

das oberflächenemittierende Laserarray (1) nach einem der Ansprüche 1 bis 7; und
einen Lichtempfänger, der dazu konfiguriert ist, Licht zu empfangen, das von den oberflächenemittierenden Laserelementen des oberflächenemittierenden Laserarrays emittiert wird.

9. Laservorrichtung, umfassend:

das oberflächenemittierende Laserarray (1) nach einem der Ansprüche 1 bis 7; und
einen Laserresonator, der ein Lasermedium in festem Zustand beinhaltet, das verursacht, dass Licht, das von dem oberflächenemittierenden Laserarray (1) emittiert wird, resoniert.

**Revendications**

1. Réseau de lasers à émission de surface (1) comprenant :

une pluralité d'éléments laser à émission de surface (20) agencés sur une première surface (10a) d'un substrat (10) et conçus pour émettre une lumière dans une direction traversant la première surface (10a) ;
une pluralité d'éléments optiques agencés sur une deuxième surface (10b) opposée à la première surface (10a) du substrat (10) pour correspondre aux éléments laser à émission de surface (20) et conçus pour modifier l'angle de rayonnement de la lumière ; et
un élément de protection contre la lumière (42) agencé dans une région située entre les éléments optiques sur la deuxième surface (10b) du substrat ;
**caractérisé en ce que** l'élément de protection contre la lumière (42) couvre des portions périphériques des éléments optiques, la portion périphérique faisant partie de l'élément optique.

2. Réseau de lasers à émission de surface (1) selon la revendication 1, dans lequel la portion périphérique couverte par l'élément de protection contre la lumière (42) sur les éléments optiques a une largeur égale ou inférieure à 10 % du diamètre des éléments optiques.

3. Réseau de lasers à émission de surface (1) selon la revendication 1 ou 2, dans lequel l'élément de protection contre la lumière (42) fonctionne en outre comme une électrode sur la deuxième surface du substrat (10).

4. Réseau de lasers à émission de surface (1) selon la revendication 1 ou 2, comprenant en outre une électrode de surface arrière constituée d'un matériau conducteur transparent et disposée sur les éléments optiques et l'élément de protection contre la lumière (42) sur la deuxième surface (10b).

5. Réseau de lasers à émission de surface (1) selon l'une quelconque des revendications 1 à 4, dans lequel

le substrat (10) est un substrat GaAs, et
les éléments laser à émission de surface comprennent des couches actives constituées d'InGaAs.

6. Réseau de lasers à émission de surface (1) selon l'une quelconque des revendications 1 à 5, dans lequel les longueurs d'onde maximales de la lumière émise par les éléments laser à émission de surface (20) se situent dans une la de 910 à 970 nanomètres.

7. Réseau de lasers à émission de surface (1) selon l'une quelconque des revendications 1 à 6, dans lequel l'épaisseur t du substrat (10) est représentée par l'expression (1), où l'angle de rayonnement de la lumière au sein du substrat (10) est désigné par $\vartheta$, le pas entre les éléments laser à émission de surface (20) est désigné par X, le diamètre de chacun des éléments optiques est désigné par $\varphi$, et la longueur de la région d'émission de lumière de chacun des éléments laser à émission de surface (20) est désignée par a.

$$t < \frac{1}{2\tan\frac{\theta}{2}}\left[X + \frac{\phi}{10} - a\right]$$

$$(1)$$

8. Dispositif de détection comprenant :

le réseau de lasers à émission de surface (1) selon l'une quelconque des revendications 1 à 7, et
un récepteur de lumière conçu pour recevoir la lumière émise par les éléments laser à émission de surface du réseau de lasers à émission de surface.

9. Dispositif laser comprenant :

le réseau de lasers à émission de surface (1) selon l'une quelconque des revendications 1 à 7, et
un résonateur laser comprenant un milieu laser à l'état solide qui entraîne une résonance de la lumière émise par le réseau de lasers à émission de surface (1).

[Fig. 1]

[Fig. 2]

[Fig. 3A]

[Fig. 3B]

[Fig. 3C]

[Fig. 4]

LASER BEAM

[Fig. 5]

[Fig. 6]

[Fig. 7]

[Fig. 8]

COATED WIDTH: h

MICROLENS DIAMETER: φ

41 (41-1)

41 (41-2)

RESIDUAL

41

42

[Fig. 9]

[Fig. 10]

[Fig. 11]

[Fig. 12]

[Fig. 13]

EP 3 769 382 B1

**LiDAR DEVICE** — 100

**CONTROL/SIGNAL PROCESSING UNIT** — 130

**LASER LIGHT SOURCE DRIVING CIRCUIT** — 131

**CONTROL CIRCUIT** — 132

**SIGNAL PROCESSING CIRCUIT** — 133

**PROJECTING UNIT** — 110

**LASER LIGHT SOURCE** — 111

113

**MOVABLE MIRROR** — 114

**LIGHT RECEIVING UNIT** — 120

**LIGHT RECEIVING ELEMENT** — 123

**OPTICAL FILTER** — 122

**CONDENSING OPTICAL SYSTEM** — 121

**SCANNING LIGHT Lscan**

**REFLECTED LIGHT Lref**

**SCANNING RANGE** — 140

**TARGET OBJECT**

141

[Fig. 14]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0205397 A2
- US 2016254638 A1
- US 2007217473 A1
- GB 2347559 A
- WO 2011021139 A2
- JP 2014007293 A